# EUROPEAN PATENT APPLICATION

(11) **EP 1 557 844 A2**
(43) Date of publication of application: **27.07.2005**
(21) Application number: 04077836.7
(22) Date of filing: 13.10.2004
(51) Int. Cl.: G21K 1/06, G02B 1/10, G03F 7/20

(54) **Use of a top layer on a mirror for use in a lithographic apparatus, mirror for use in a lithographic apparatus, lithographic apparatus comprising such a mirror and device manufacturing method**

(30) Priority: 20.10.2003 EP 03078316
(71) Applicant: ASML Netherlands B.V., 5503 LA Veldhoven (NL)
(72) Inventor: Bakker, Levinus Pieter, 5708 ZT Helmond (NL); Schuurmans, Frank Jeroen Pieter, 5551 XE Valkenswaard (NL)
(74) Representative: van Westenbrugge, Andries

(57) **Abstract**

Use of a top layer (8) of a predetermined metal on a mirror for use in a lithographic apparatus, mirror for use in a lithographic apparatus and a lithographic apparatus with such a mirror or a mirror provided with a top layer with such a use. The apparatus has a source (SO) to provide radiation of a desired wavelength, e.g., EUV. The source (SO) generates a stream of undesired metal particles that are deposited to form smaller and larger nuclei on the mirror. The top layer (8) may interdiffuse in a predetermined temperature range with nuclei of the metal deposition. Thus, an additional layer (14) of an alloy of the metal particles and the metal of the top layer (8) is formed that has a higher reflectivity than a layer only comprising the metal particles would have.

## Description

The present invention relates to a lithographic apparatus and a device manufacturing method.

A lithographic apparatus is a machine that applies a desired pattern onto a target portion of a substrate. Lithographic apparatus can be used, for example, in the manufacture of integrated circuits (ICs). In that circumstance, a patterning means, such as a mask, may be used to generate a circuit pattern corresponding to an individual layer of the IC, and this pattern can be imaged onto a target portion (e.g. comprising part of, one or several dies) on a substrate (e.g. a silicon wafer) that has a layer of radiation-sensitive material (resist). In general, a single substrate will contain a network of adjacent target portions that are successively exposed. Known lithographic apparatus include so-called steppers, in which each target portion is irradiated by exposing an entire pattern onto the target portion in one go, and so-called scanners, in which each target portion is irradiated by scanning the pattern through the projection beam in a given direction (the "scanning"-direction) while synchronously scanning the substrate parallel or anti-parallel to this direction.

In the near future, extreme ultraviolet (EUV) sources, will probably use tin or another metal vapor to produce EUV radiation. This tin may leak into the lithographic apparatus, and will be deposited on mirrors in the lithographic apparatus, e.g., the mirrors of the radiation collector. The mirrors of such a radiation collector are foreseen to be multilayered and may have a EUV reflecting top layer of ruthenium (Ru). Deposited layers of more than approximately 10 nm tin (Sn) on the reflecting Ru layer will reflect EUV radiation in the same way as bulk Sn. It is envisaged that a layer of 10 nm Sn is deposited very quickly near a Sn-based EUV source. The overall transmission of the collector will decrease significantly, since the reflection coefficient of tin is much lower than the reflection coefficient of ruthenium.

It is an object of the present invention to provide a mirror, and other means and methods to keep the overall EUV transmission of the mirror as high as possible.

According to one aspect of the invention, a top layer of a predetermined metal is used on a mirror for use in a lithographic apparatus comprising a source to provide radiation of a desired wavelength to reduce the forming of a metal deposition on the mirror by a stream of undesired metal particles generated by the source in operation, the predetermined metal being selected such that it interdiffuses in a predetermined temperature range with the metal deposition, when the lithographic apparatus is in operation.

The general idea behind this invention is as follows. The mirror may have a top layer of a metal with a very high reflectivity, e.g., a multi-layer mirror provided with a top layer of Ru. Without a stream of undesired metal particles, a radiation collector provided with such a mirror would have a transmission for EUV of 77%. However, if such a mirror collects such undesired metal particles the reflectivity and transmission is reduced drastically. For instance, if the undesired metal particles comprise Sn and the Sn is deposited as a layer of 10 nm or more, the transmission of such a multi-layer mirror may reduce to 21% for EUV. In accordance with this invention, the top layer is now selected such that the metal of the top layer interdiffuses with the undesired metal particles when deposited on the top layer. For instance, when the undesired metal particles are Sn, the top layer may be made of Au. Then, an Au/Sn alloy film will result on the top layer of Au. The collector transmission of such a mirror may be approximately 0.40, which is significantly higher than the transmission of 0.21 of a mirror with a Sn layer only.

Instead of Au other elements of group Ib may be used. Pd may be used too.

In a further embodiment, the invention relates to a use of a top layer of one or more predetermined materials on a mirror for use in a lithographic apparatus comprising a source to provide radiation of a desired wavelength and that, in operation, generates a stream of undesired metal particles to form a metal deposition on the mirror to extend lifetime of nuclei in a nucleation stage of the metal deposition, which nuclei will be formed when the metal particles are deposited on the top layer when the lithographic apparatus is in operation.

When the one or more predetermined materials are selected to extend lifetime of nuclei in a nucleation stage of the metal deposition, the thin film growth will be in the nucleation stage as long as possible and a coalescence process will be delayed as much as possible, thereby avoiding a continuous film to be formed on the mirror as long as possible.

In a further embodiment, the invention relates to a mirror for use in a lithographic apparatus comprising a source to provide radiation of a desired wavelength and that, in operation, generates a stream of undesired metal particles to form a metal deposition on the mirror, the mirror being, at least partly, covered with a top layer of one or more predetermined materials, the one or more predetermined materials being selected such that it enhances wetting of the metal deposition only on predetermined areas of the top layer.

Here, "wetting" is defined as the tendency of a liquid to spread over a surface. The higher the wetting by the liquid, the lower a contact angle between the liquid and the surface. Here, the metal deposition is in the form of a liquid. When the one or more predetermined materials enhance wetting of the metal deposition only on predetermined areas of the top layer, the mirror collects undesired metal particles but stimulates nucleation only on those predetermined areas, thereby keeping the mirror outside those predetermined areas as clean as possible. Thereby, the areas outside these predetermined areas can reflect EUV radiation as good as possible.

In a further embodiment the present invention relates to a mirror for use in a lithographic apparatus comprising a source to provide radiation of a desired wavelength and that, in operation, generates a stream of undesired metal particles, the mirror being designed to gather and remove the metal particles by capillary action when they are deposited on the mirror when the lithographic apparatus is in operation.

In order to gather and remove those undesired metal particles, the mirror may comprise at least one of trenches and holes in the mirror that are, preferably, coated with a wetting material. These trenches and holes collect nuclei of the undesired metal particles and guide them away from the reflective mirror surface.

The invention also relates to a lithographic apparatus that is provided with one or more of the mirrors as defined above or that uses a top layer on one or more of the mirrors as defined above.

Such a lithographic apparatus may be provided with a heating source to heat the mirror and increase surface mobility of the undesired metal particles on the mirror. Thereby, the deposited undesired metal particles will be evaporated more easily. The evaporation of the undesired metal particles may, moreover, be stimulated by providing a predetermined halogen gas to the surface of the mirror.

In a further embodiment, the invention relates to a device as manufactured by such a lithographic apparatus as defined above.

In a further embodiment, the present invention relates to a lithographic apparatus according to claim 20. The lithographic apparatus according to claim 20 comprises a heating source to heat the mirror and increase surface mobility of the metal particles on the mirror, thereby stimulating evaporation of these metal particles from the mirror.

In an embodiment, such evaporated metal particles may be pumped away by means of a pump.

Such a lithographic apparatus may comprise a plurality of mirrors arranged as a radiation collector, at least one mirror comprising a rear surface facing a front surface of another mirror, the rear surface of the at least one mirror being arranged to receive metal particles evaporated from the front surface of the other mirror and to operate as a condensation surface. Such a condensation surface may be formed by a separate unit behind the at least one mirror, or may be the rear surface of the at least one mirror itself. It functions as a cooling object for the evaporated metal particles in order to stimulate condensation.

Also in this lithographic apparatus, a predetermined halogen gas may be used.

Also this lithographic apparatus may be used to manufacture devices, like substrates.

Although specific reference may be made in this text to the use of lithographic apparatus in the manufacture of ICs, it should be understood that the lithographic apparatus described herein may have other applications, such as the manufacture of integrated optical systems, guidance and detection patterns for magnetic domain memories, liquid-crystal displays (LCDs), thin-film magnetic heads, etc. The skilled artisan will appreciate that, in the context of such alternative applications, any use of the terms "wafer" or "die" herein may be considered as synonymous with the more general terms "substrate" or "target portion", respectively. The substrate referred to herein may be processed, before or after exposure, in for example a track (a tool that typically applies a layer of resist to a substrate and develops the exposed resist) or a metrology or inspection tool. Where applicable, the disclosure herein may be applied to such and other substrate processing tools. Further, the substrate may be processed more than once, for example in order to create a multi-layer IC, so that the term substrate used herein may also refer to a substrate that already contains multiple processed layers.

The terms "radiation" and "beam" used herein encompass all types of electromagnetic radiation, including ultraviolet (UV) radiation (e.g. having a wavelength of 365, 248, 193, 157 or 126 nm) and extreme ultra-violet (EUV) radiation (e.g. having a wavelength in the range of 5-20 nm), as well as particle beams, such as ion beams or electron beams.

The term "patterning means" used herein should be broadly interpreted as referring to means that can be used to impart a projection beam with a pattern in its cross-section such as to create a pattern in a target portion of the substrate. It should be noted that the pattern imparted to the projection beam may not exactly correspond to the desired pattern in the target portion of the substrate. Generally, the pattern imparted to the projection beam will correspond to a particular functional layer in a device being created in the target portion, such as an integrated circuit.

Patterning means may be transmissive or reflective. Examples of patterning means include masks, programmable mirror arrays, and programmable LCD panels. Masks are well known in lithography, and include mask types such as binary, alternating phase-shift, and attenuated phase-shift, as well as various hybrid mask types. An example of a programmable mirror array employs a matrix arrangement of small mirrors, each of which can be individually tilted so as to reflect an incoming radiation beam in different directions; in this manner, the reflected beam is patterned. In each example of patterning means, the support structure may be a frame or table, for example, which may be fixed or movable as required and which may ensure that the patterning means is at a desired position, for example with respect to the projection system. Any use of the terms "reticle" or "mask" herein may be considered synonymous with the more general term "patterning means".

The term "projection system" used herein should be broadly interpreted as encompassing various types of projection system, including refractive optical systems, reflective optical systems, and catadioptric optical systems, as appropriate for example for the exposure radiation being used, or for other factors such as the use of an immersion fluid or the use of a vacuum. Any use of the term "lens" herein may be considered as synonymous with the more general term "projection system".

The illumination system may also encompass various types of optical components, including refractive, reflective, and catadioptric optical components for directing, shaping, or controlling the projection beam of radiation, and such components may also be referred to below, collectively or singularly, as a "lens".

The lithographic apparatus may be of a type having two (dual stage) or more substrate tables (and/or two or more mask tables). In such "multiple stage" machines the additional tables may be used in parallel, or preparatory steps may be carried out on one or more tables while one or more other tables are being used for exposure.

The lithographic apparatus may also be of a type wherein the substrate is immersed in a liquid having a relatively high refractive index, e.g. water, so as to fill a space between the final element of the projection system and the substrate. Immersion liquids may also be applied to other spaces in the lithographic apparatus, for example, between the mask and the first element of the projection system. Immersion techniques are well known in the art for increasing the numerical aperture of projection systems.

Embodiments of the invention will now be described, by way of example only, with reference to the accompanying schematic drawings in which corresponding reference symbols indicate corresponding parts, and in which:
- Figure 1 depicts a lithographic apparatus according to an embodiment of the invention;
- Figure 2 shows some parts of figure 1 in more detail;
- Figure 3 shows a portion of a mirror that can, e.g., be used in a radiation collector in the system according to figure 2;
- Figures 4a-4c show portions of a mirror according to a first embodiment of the invention;
- Figure 4d is a graph showing mirror transmission of EUV as a function of a deposited Sn layer thickness;
- Figures 5a-5d show different stages of thin film growth on the mirror surface as an introduction to a second embodiment of the invention;
- Figure 6 shows an embodiment of a mirror of the invention;
- Figure 7 shows a further embodiment of a mirror of the present invention;
- Figure 8 shows part of a radiation collector according to the invention;
- Figure 9 shows a front surface of a mirror according to the invention.

### EMBODIMENTS

In the embodiments, like reference numerals refer to the same components or elements.

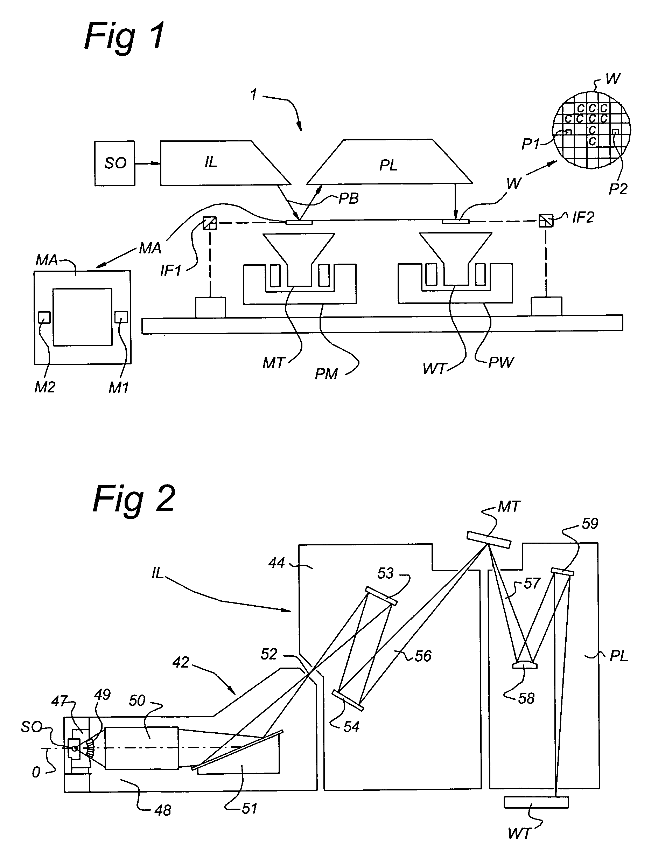

Figure 1 schematically depicts a lithographic apparatus according to a particular embodiment of the invention. The apparatus comprises:
- an illumination system (illuminator) IL for providing a projection beam PB of radiation (e.g. UV or EUV radiation).
- a first support structure (e.g. a mask table) MT for supporting patterning means (e.g. a mask) MA and connected to first positioning means PM for accurately positioning the patterning means with respect to item PL;
- a substrate table (e.g. a wafer table) WT for holding a substrate (e.g. a resist-coated wafer) W and connected to second positioning means PW for accurately positioning the substrate with respect to item PL; and
- a projection system (e.g. a reflective projection lens) PL for imaging a pattern imparted to the projection beam PB by patterning means MA onto a target portion C (e.g. comprising one or more dies) of the substrate W.

As here depicted, the apparatus is of a reflective type (e.g. employing a reflective mask or a programmable mirror array of a type as referred to above). Alternatively, the apparatus may be of a transmissive type (e.g. employing a transmissive mask).

The illuminator IL receives a beam of radiation from a radiation source SO. The source and the lithographic apparatus may be separate entities, for example when the source is a plasma discharge source. In such cases, the source is not considered to form part of the lithographic apparatus and the radiation beam is generally passed from the source SO to the illuminator IL with the aid of a radiation collector comprising for example suitable collecting mirrors and/or a spectral purity filter. In other cases the source may be integral part of the apparatus, for example when the source is a mercury lamp. The source SO and the illuminator IL, may be referred to as a radiation system.

The illuminator IL may comprise adjusting means for adjusting the angular intensity distribution of the beam. Generally, at least the outer and/or inner radial extent (commonly referred to as σ-outer and σ-inner, respectively) of the intensity distribution in a pupil plane of the illuminator can be adjusted. The illuminator provides a conditioned beam of radiation, referred to as the projection beam PB, having a desired uniformity and intensity distribution in its cross-section.

The projection beam PB is incident on the mask MA, which is held on the mask table MT. Being reflected by the mask MA, the projection beam PB passes through the lens PL, which focuses the beam onto a target portion C of the substrate W. With the aid of the second positioning means PW and position sensor IF2 (e.g. an interferometric device), the substrate table WT can be moved accurately, e.g. so as to position different target portions C in the path of the beam PB. Similarly, the first positioning means PM and position sensor IF 1 can be used to accurately position the mask MA with respect to the path of the beam PB, e.g. after mechanical retrieval from a mask library, or during a scan. In general, movement of the object tables MT and WT will be realized with the aid of a long-stroke module (coarse positioning) and a short-stroke module (fine positioning), which form part of the positioning means PM and PW. However, in the case of a stepper (as opposed to a scanner) the mask table MT may be connected to a short stroke actuator only, or may be fixed. Mask MA and substrate W may be aligned using mask alignment marks M1, M2 and substrate alignment marks P1, P2.

The depicted apparatus can be used in the following preferred modes:
1. In step mode, the mask table MT and the substrate table WT are kept essentially stationary, while an entire pattern imparted to the projection beam is projected onto a target portion C in one go (i.e. a single static exposure). The substrate table WT is then shifted in the X and/or Y direction so that a different target portion C can be exposed. In step mode, the maximum size of the exposure field limits the size of the target portion C imaged in a single static exposure.
2. In scan mode, the mask table MT and the substrate table WT are scanned synchronously while a pattern imparted to the projection beam is projected onto a target portion C (i.e. a single dynamic exposure). The velocity and direction of the substrate table WT relative to the mask table MT is determined by the (de-)magnification and image reversal characteristics of the projection system PL. In scan mode, the maximum size of the exposure field limits the width (in the non-scanning direction) of the target portion in a single dynamic exposure, whereas the length of the scanning motion determines the height (in the scanning direction) of the target portion.
3. In another mode, the mask table MT is kept essentially stationary holding a programmable patterning means, and the substrate table WT is moved or scanned while a pattern imparted to the projection beam is projected onto a target portion C. In this mode, generally a pulsed radiation source is employed and the programmable patterning means is updated as required after each movement of the substrate table WT or in between successive radiation pulses during a scan. This mode of operation can be readily applied to maskless lithography that utilizes programmable patterning means, such as a programmable mirror array of a type as referred to above.

Combinations and/or variations on the above described modes of use or entirely different modes of use may also be employed.

Fig. 2 shows the projection apparatus 1 in more detail, comprising a radiation system 42, an illumination optics unit 44, and the projection optics system PL. The radiation system 42 comprises the radiation source SO which may be formed by a discharge plasma. EUV radiation may be produced by a gas or vapor, such as Xe gas, Li vapor or Sn vapor in which a very hot plasma is created to emit radiation in the EUV range of the electromagnetic spectrum. The very hot plasma is created by causing a partially ionized plasma of an electrical discharge to collapse onto an optical axis O. Partial pressures of 10 Pa of Xe, Li, Sn vapor or any other suitable gas or vapor may be required for efficient generation of the radiation. The radiation emitted by radiation source SO is passed from a source chamber 47 into a collector chamber 48 via a gas barrier structure or contamination trap 49. The gas barrier structure 49 comprises a channel structure such as, for instance, described in detail in European patent applications EP-A-1 233 468 and EP-A-1- 057 079, which are incorporated herein by reference.

The collector chamber 48 comprises a radiation collector 50 which may be formed by a grazing incidence collector. Radiation passed by collector 50 is reflected off a grating spectral filter 51 to be focused in a virtual source point 52 at an aperture in the collector chamber 48. From collector chamber 48, a projection beam 56 is reflected in illumination optics unit 44 via normal incidence reflectors 53, 54 onto a reticle or mask positioned on reticle or mask table MT. A patterned beam 57 is formed which is imaged in projection optics system PL via reflective elements 58, 59 onto wafer stage or substrate table WT. More elements than shown may generally be present in illumination optics unit 44 and projection system PL.

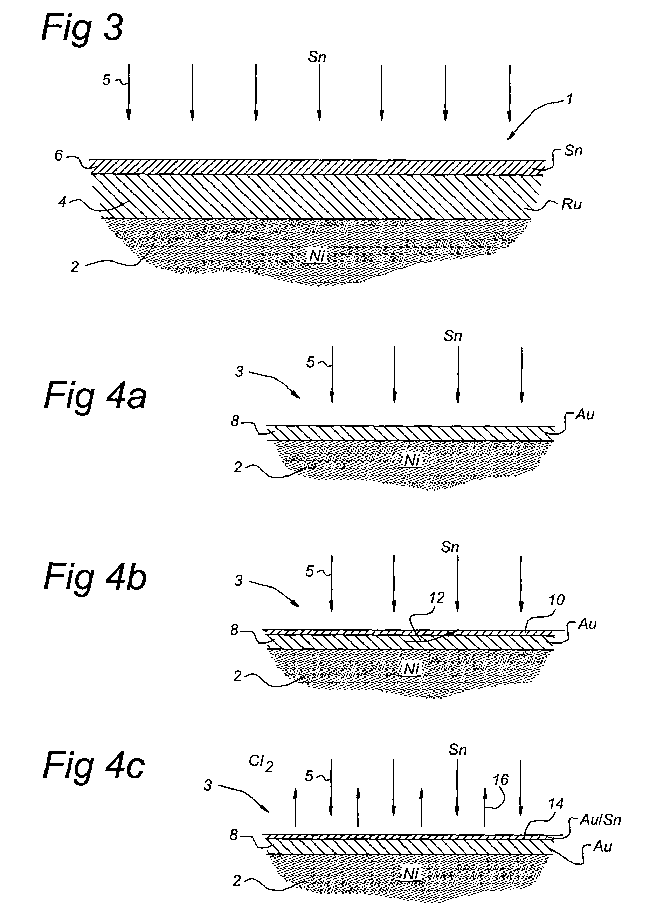

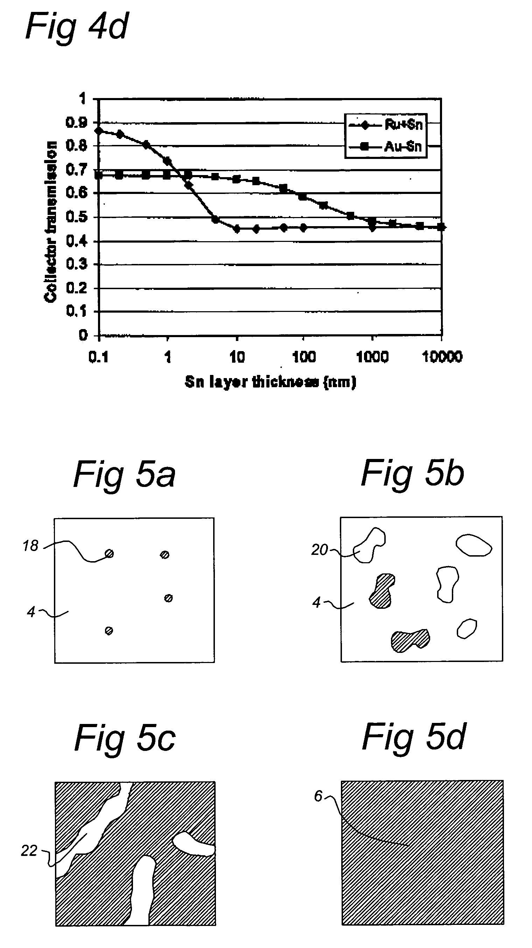

Radiation collectors 50 are known from the prior art. One example of a radiation collector that may be used in the present invention is, e.g., described in patent application EP 03077675.1. (See especially figures 3 and 4). The present invention will now be illustrated with reference to a radiation source SO based on a discharge plasma in a Sn vapor. However, it is to be understood that the general idea of the present invention may also work for other metal vapors.

Figure 3 shows a portion of a mirror that can be used in the arrangement shown in figures 1 and 2. The mirror shown in figure 3 can, advantageously, be used as one of the mirrors in the radiation collector 50. Such a mirror may, as is known to persons skilled in the art, be made as a multi-layer mirror having a top layer 4 on a layer 2. There may be provided more layers below layer 2. The layer 2 may be made of Ni, whereas the top layer 4 may be made of Ru.

In the near future, the radiation source SO may use Sn in order to produce extreme ultraviolet (EUV) radiation. This may be done by using tin (Sn) vapor. Part of this Sn will leak from the source chamber 47 into the collector chamber 48. Despite using the contamination trap 49, and possibly other means for and methods of reducing this Sn escaped from the source chamber 47, part of this Sn may reach the mirrors of the radiation collector 50. There, Sn will be deposited on the reflecting Ru layer 4 of the radiation collector mirrors, as indicated with reference number 5. A Sn layer 6 will be thus be formed on the Ru layer 4. The Sn layer 6 on top of the Ru layer 4 reduces the transmission of the mirror 1.The collector transmission is defined as the effect of two reflections with an angle of incidence of 10 degrees with respect to the mirroring surface. The transmission coefficient is thus equal to the square of the reflection coefficient for a single reflection. These two reflections are an approximation for the behaviour of the collector. As defined in this way, the transmission of such a radiation collector 50 with pure Ru for EUV is 77%. However, if the Sn layer 6 is 10 nm or more, this transmission of the radiation collector 50 for EUV reduces to 21%.

In accordance with one embodiment of the invention, the influence of Sn on the reflectance of the top layer of the mirror 1 is reduced by increasing interdiffusion of Sn and a predetermined optical material for the top layer of the mirror 1.

The reflectance of an optical coating on a mirror for EUV radiation is determined by the composing elements only, and chemical effects can be neglected (Spiller, *Soft x-ray optics,* SPIE Press, Washington, 1994. p. 7). The optical constants of mixtures are equal to the sum of the optical constants of composing elements of the mixture, weighted with their atom density. Therefore, it is beneficial to have as much "good reflecting" atoms, and as little Sn atoms near the reflecting surface of the mirror 1 as possible. In order to reduce the influence of Sn on the reflectance of the mirror 1, it is therefore proposed to have an optical coating as a top layer on the mirror 1 that may mix with Sn, thus, creating a mixture with enough reflecting material at the mirror surface to have a reasonable reflectance.

"Good reflecting" atoms for EUV, e.g., 13.5 nm, radiation are Mo, Nb, Ru, Zr, Rh, Pd, Au, and others. Intermixing of these atoms with Sn depends on the temperature. This gives one parameter to control. Another parameter is the material, of which the optical coating layer is made. It is known that diffusion of group Ib elements, comprising Au, Ag, and Cu, into group IIIb and into group IVb host metals, such as Al, C, Si, Sn, can be very rapid (Nakahara, et al., *Thin Solid Films* 84 (1981), pp. 185-196; note, that for the groups nomenclature, the *European Group Labelling Scheme* is used). Moreover, the interdiffusion and phase formation in Au/Sn thin films has been studied extensively (Hugsted, et al., *Thin Solid Films* 98 (1982), pp. 81-94). It is known that their interdiffusion is very high, even at room temperature. Therefore, a gold coating as an EUV reflector on mirror 1 in a Sn depositing environment is advantageous. Near the melting temperature of an alloy of Au and Sn, interdiffusion is very high. The melting point of a standard solder comprising 80% Au and 20% Sn is 554 K (281°C), i.e., very low. However, for other combinations with Sn other melting points will be found, e.g., in the range between room temperature and 2800 K. For an alloy of Au and Sn, the temperature range of melting points is between room temperature and 1337 K.

In an embodiment of the present invention, it is therefore proposed to provide a mirror 3 with a top coating 8 made of Au, as shown in figure 4a. This Au top coating 8 may be on top of Ni layer 2.

As shown in figure 4b, Sn is deposited, as indicated with reference numeral 5, on Au top coating 8. During the process of deposition of Sn atoms on the Au top coating 8, a thin layer 10 of Sn will be formed, as shown in figure 4b. Au atoms of Au top coating 8 will diffuse into this layer of Sn, as is indicated with arrow 12. Thus a layer 14 of Au/Sn will be formed on top of the Au top coating 8. This is shown in figure 4c. Since the mirror 3 will be heated by the EUV radiation (not shown in figure 4b) incident on the mirror 3, the interdiffusion rate will increase with respect to room temperature operation.

This alloy film 14 can be used as reflector layer on the mirror 3. Such a mirror 3 can, e.g. be used in the radiation collector 50. The collector transmission of the mirror 3 with Au/Sn alloy film 14 is approximately 0.40. This is significantly higher than the transmission of 0.21 of a mirror with a Sn layer 6 only.

A disadvantage of using Au may be that the initial transmission, i.e. transmission before any Sn is deposited on the mirror surface, is only 0.46, compared to 0.77 for pure Ru. However, the transmission of the mirror 3 is kept significantly higher than 0.21 for pure Sn for a much longer period.

This is shown in figure 4d. Figure 4d shows the calculated transmission of a mirror as a function of deposited Sn layer thickness. Figure 4d shows two situations. In the first situation Sn is deposited on a Ru layer 4 (figure 3). In the second situation, Sn is deposited on Au top coating 8 (figures 4a-4c). For the Au/Sn alloy case (figure 4c), it is assumed that the Au/Sn alloy layer 14 is a homogeneous mixture of 100 nm Au and the Sn layer. It is observed that the Sn layer thickness is shown on a logarithmic scale.

Since the Sn deposition is a continuous process, the Au/Sn top coating 14 will, in operation, be covered with Sn. So, care has to be taken that the deposited Sn will not result in an alloy which is too Sn rich, and that the deposited Sn is mixed with the Au, instead of remaining on top of the Au/Sn alloy layer 14. Depending on the thickness of the Au/Sn alloy layer 14, the mirror 3 can handle a certain amount of Sn to be deposited. This translates into the fact that the thickness of the Au/Sn alloy layer 14 where the transmission of the mirror 3 starts decreasing, which is about 20 nm in figure 4d, depends on the initial thickness of the Au layer 8. Increasing this initial thickness of the Au layer 8 results in more Sn absorption capacity. The Au layer may typically be in the range between 10 nm - 10 micron.

The continuous deposition of Sn necessitates the removal of Sn from the Au layer 8. One way to do that is by "baking out", i.e., increasing the temperature of the Au/Sn alloy layer 14 in order to stimulate evaporation of Sn as a Sn vapor 16 (figure 4c). An arrangement for heating the mirror 3 will be discussed hereinafter with reference to figure 8.

A disadvantage of the Au/Sn alloy layer 14 is that the Sn vapor pressure for the Au/Sn alloy is lower than for pure Sn. Thus, removing the Sn from the Au/Sn alloy layer 14 requires a higher temperature than is needed to remove pure Sn from a surface. The fact that evaporation from the mirror surface results in slightly decreased Sn concentration at the upper surface of the Au/Sn alloy layer 14 will result in a higher reflectance since, then, a higher percentage of Au atoms will be present near this upper surface. This is beneficial with respect to non-interdiffusion combinations. In order to get more Sn into the vapor phase, it is also possible to add a halogen gas like Cl₂, Br₂ or I₂. The vapor pressure of metal-halides is usually higher than the vapor pressure for pure metals. So, adding a halogen gas enhances the evaporation process.

Depending on the amount of Sn that is deposited on the mirror 3, a choice can be made between different reflecting materials. The inventor of the present invention has calculated the effect of interdiffusion for two cases: (1) no interdiffusion combined with a high initial reflection (e.g., Ru) and (2) very high interdiffusion combined with a low initial reflection (e.g., Au). For very low Sn doses, a Ru mirror is advantageous. However, the reflection of a Ru coated mirror drops quite dramatically for very thin Sn layers, as is already explained with reference to figure 4d. On the other hand, an Au coated mirror can maintain its initial transmission for a much longer period, as is also explained with reference to figure 4d. Other materials are expected to perform intermediately. For instance, Pd has a higher initial reflection than Au, however, Pd performs worse in interdiffusion.

It is observed that the method as described with reference to figures 4a-4d does not only work for Sn vapors but also for other metal vapors, be it that interdiffusion will be higher for elements with a lower melting point. Note, that Sn has a very low melting point of 504,8 K (231.8°C) (see also, Marinkovic, et al., *Thin Solid Films,* 217(1992), pp. 26-30).

In accordance with an other embodiment, the present invention proposes to reduce the influence of Sn on the reflectance of the mirror in two ways: Firstly, keeping one or more parts of the reflecting mirror surface free from deposited Sn, such that incident EUV radiation on those parts is directly incident on Ru (or another good EUV reflector), and secondly removing the Sn from the surface.

First of all, an explanation as to how thin films grow on a surface will be given with reference to figure 5a-5d that show top views of a mirror on which a thin film grows. Usually, thin films grow on a surface in the following stages:
1. Nucleation stage, where small nuclei are formed. See figure 5a, where these small nuclei 18 of Sn are shown on Ru layer 4. These nuclei 18 grow until they start touching each other, which occurs at a density, which is generally referred to as the saturation density. The nucleation can be defect-induced or random.
2. Coalescence stage, where touching nuclei transform into one single larger nucleus 20, as shown in figure 5b, reducing the surface free energy. The larger nuclei 20 keep growing. Surface diffusion is the main transport mechanism.
3. Channel stage, where the individual larger nuclei 20 grow faster than during the coalescence process, creating more continuous channels 22 with voids and grain boundaries, cf figure 5c.
4. Continuous film stage, where the full area is covered with a continuous film 6, as shown in figure 5d (which is a top view of figure 3), which film consists of grains connected by grain boundaries.

It is proposed to keep the thin film growth as long as possible in the nucleation stage, having a saturation density as high as possible. This can, for instance, be accomplished in the following ways.

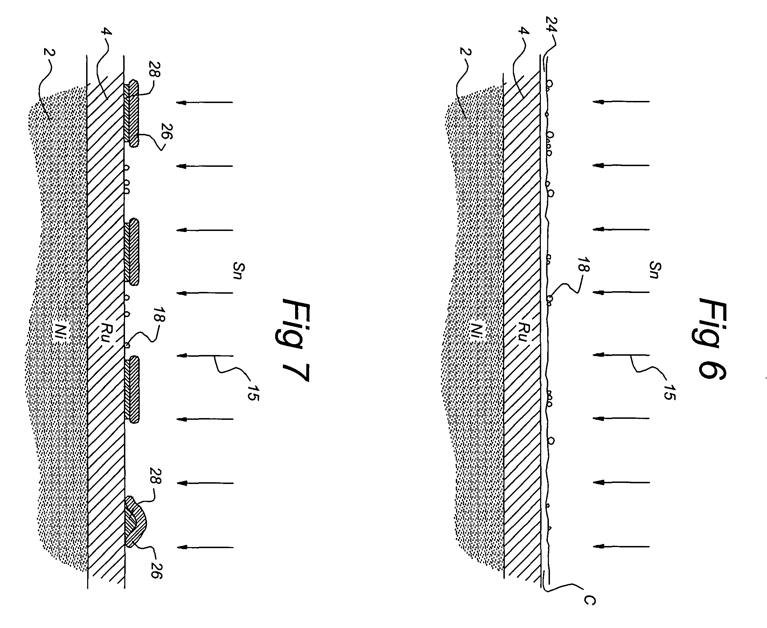

In one embodiment, the surface mobility of Sn on the mirror surface is increased by applying a protective coating 24 of for instance carbon (C) on top of the Ru (or other) layer 4, as shown in figure 6. This protective coating 24 can also be used for the reduction of chemical reactions of Ru (or other) layer 4 with Sn. Hence it prevents a Sn continuous film to be formed and helps keeping a large part of the Ru (or other) layer 4 clean. Preferably, the protective coating 24 is selected from a material that is not easily wetted by Sn.

In an other embodiment, growth (nucleation) sites are created artificially. The deposited Sn will gather on these nucleation sites during the nucleation stage. As shown in figure 7, this can, for instance, be done by depositing growth sites 28 of a predetermined material in the form of 'dots' on the Ru (or other) layer 4 in any desired density pattern that is suitable for illumination by EUV. Other possible nucleation sites are holes, trenches, lines, and other shapes. The growth sites 28 are preferably made of a material that is easily wetted by Sn, as, for instance, copper (Cu). They may be largely flat, line shaped or dot shaped. The deposited Sn then forms similarly shaped deposition sites 26 on top of the growth sites 28.

In a further embodiment, the temperature of the Ru layer 4 is increased to increase the surface mobility of Sn on Ru layer 4. This will keep possible nucleation sites for the Sn incident on the mirror a larger distance apart. The Sn will be gathered at the nucleation sites, keeping a large part of the Ru layer 4 clean. Thereby, the overall transmission of the mirror remains on a higher level. This may, e.g., be done with the arrangement shown in figure 8.

Figure 8 schematically shows a heat source 38 controlled by a controller 40. The heat source 38 may be connected to mirror 30(1) by connection parts 31. The connection parts 31 may be heat conductive. The controller 40 may be implemented as a suitably programmed computer, or a controller with suitable analogue and/or digital circuits. The heat source 38 generates heat, indicated with arrows 37, which is directed to a first mirror of 30(1) of radiation collector 50. The radiation collector 50 is shown to comprise a second mirror 30(2). As is known to persons skilled in the art, the radiation collector may comprise more than two mirrors to collect EUV radiation 35 and to produce projection beam 56.

Behind mirror 30(2) a cold unit 33 is provided, arranged opposite to the front surface of mirror 30(1), i.e., the surface of mirror 30(1) receiving EUV radiation 35. The cold unit 33 is termed "cold" since it is arranged outside the EUV radiation 35, i.e., in the shadow of mirror 30(2), and can, therefore, not be heated by EUV radiation 35. Dotted lines indicate how EUV radiation 35 is directed towards and reflected by mirror 30(1). These dotted lines also show that the cold unit 33 does not even receive EUV radiation reflected by mirror 30(1). Areas adjacent to cold unit 33 indicated with reference numerals 32, 34 are, thus, dark areas where no EUV radiation is present. Cold unit 33 may be attached to mirror 30(2), although it is preferred that no heat transfer from mirror 30(2) towards cold unit 33 occurs. Reference numerals 36 in mirrors 30(1) and 30(2) indicate possible through-holes.

In an alternative embodiment, mirror 30(1) could be actively cooled, e.g., by a Peltier element connected to the rear surface of mirror 30(2). This Peltier element should have a cool surface towards mirror 30(1) and a heat removal side towards mirror 30(2), to cool mirror 30(1) and heat mirror 30(2).

In operation, the heat produced by the heat source 38, heats Sn after being deposited on mirror 30(1), thus, stimulating evaporation 16 of Sn from the surface of mirror 30(1). The evaporated Sn is largely directed towards the cold unit 33 on which surface the evaporated Sn will condensate. After some predetermined operation time, the cold unit 33 may be replaced by a clean one. The cold unit 33 may be cleaned in-situ or ex-situ. An additional advantage of the set-up of figure 8 is that the mirror 30(1) is additionally cooled by the evaporation of the Sn. Of course, the other mirror 30(2) may be heated in a similar way and may face an other cold unit. Evaporated Sn may be pumped away by a pump 29 that is connected to and controlled by controller 40.

The through-holes 36 are designed such that they have a capillary action for the Sn on the mirror surface, i.e., they collect Sn and transport it away to the rear mirror surface not receiving EUV radiation. To that effect, they may be provided with a wetting coating, e.g., made of Ag or Cu, to improve wetting by Sn, i.e. to arrange the surface in such a way that Sn, in the case it makes contact with the coating, spreads out over the entire surface of the coating. At the rear surface Sn sinks (not shown) may be provided.

Alternatively, or in addition, capillary trenches 39, possibly provided with a wetting coating, may be provided either on the front surface or on the rear surface or both, as shown in figure 9. These capillary trenches 39 collect Sn and transport Sn away, e.g., to the edge of the mirror where it may be collected by a Sn sink (not shown). The capillary trenches 39 may be connected to the through-holes 36 (if applied) such that Sn collected at the front side is transported to the rear side through the through-holes and from there transported to Sn sinks.

It is observed that the set-up of figure 8 can be applied with or without the mirrors as shown in figures 3-7.

Also in the set-up of figure 8, (as in the other embodiments), halides may be introduced in the system in order to have more Sn containing vapor.

While specific embodiments of the invention have been described above, it will be appreciated that the invention may be practiced otherwise than as described. The description is not intended to limit the invention.

## Claims

1. Use of a top layer (8) of a predetermined metal on a mirror for use in a lithographic apparatus comprising a source (SO) to provide radiation of a desired wavelength to reduce the forming of a metal deposition on said mirror by a stream of undesired metal particles, generated by said source in operation, the predetermined metal being selected such that it interdiffuses in a predetermined temperature range with said metal deposition, when said lithographic apparatus is in operation.

2. Use of a top layer (8) of a predetermined metal on a mirror according to claim 1, wherein said predetermined temperature range is 300-2800 K.

3. Use of a top layer (8) of a predetermined metal on a mirror according to claims 1 or 2, wherein said predetermined metal is at least one of group Ib elements, like Au, or Pd.

4. Use of a top layer (8) of a predetermined metal on a mirror according to claim 3, wherein said undesired metal particles are one of Sn and Li.

5. Use of a top layer (24) of one or more predetermined materials on a mirror for use in a lithographic apparatus comprising a source (SO) to provide radiation of a desired wavelength and that, in operation, generates a stream of undesired metal particles to form a metal deposition on said mirror, to extend lifetime of nuclei in a nucleation stage of said metal deposition, which nuclei will be formed when said metal particles are deposited on said top layer when said lithographic apparatus is in operation.

6. Use of a top layer (24) of one or more predetermined materials on a mirror according to claim 5, wherein said one or more predetermined materials comprises a non-wetting material that may be C.

7. Mirror for use in a lithographic apparatus comprising a source (SO) to provide radiation of a desired wavelength and that, in operation, generates a stream of undesired metal particles to form a metal deposition on said mirror, the mirror being, at least partly, covered with a top layer (28) of one or more predetermined materials, said one or more predetermined materials being selected such that it enhances wetting of said metal deposition only on predetermined areas of said top layer (28).

8. Mirror according to claim 7, wherein said one or more predetermined materials comprises a wetting material, e.g. Ag or Cu, and is arranged in a pattern of at least one of dots and lines.

9. Mirror for use in a lithographic apparatus comprising a source (SO) to provide radiation of a desired wavelength and that, in operation, generates a stream of undesired metal particles, the mirror having a structure to gather and remove said metal particles by capillary action when they are deposited on said mirror when said lithographic apparatus is in operation.

10. Mirror according to claim 9, wherein said structure comprises at least one of capillary trenches (39) and through holes (36) in said mirror, that may be coated with a wetting material.

11. A lithographic apparatus comprising:
- an illumination system for providing a projection beam of radiation;
- a support structure for supporting patterning means, the patterning means serving to impart the projection beam with a pattern in its cross-section;
- a substrate table for holding a substrate; and
- a projection system for projecting the patterned beam onto a target portion of the substrate,
**characterized in that**
said illumination system comprises at least one mirror according to any of the claims 7-10 or as provided with a top layer that is used according to any of the claims 1-6.

12. Lithographic apparatus according to claim 11, wherein said lithographic apparatus comprises a radiation source (SO) to provide radiation of a desired wavelength and, in operation, generates a stream of undesired metal particles.

13. Lithographic apparatus according to claim 12, wherein said desired wavelength is in the EUV range.

14. Lithographic apparatus according to claims 12 or 13, wherein said metal particles comprise one of Sn and Li.

15. Lithographic apparatus according to any of the claims 11-14, wherein the mirror is part of a radiation collector (50).

16. Lithographic apparatus according to any of the claims 11-15, comprising a contamination trap (49).

17. Lithographic apparatus according to any of the claims 11-16, wherein the lithographic apparatus comprises a heat source (38) to heat said mirror and increase surface mobility of said undesired metal particles on said mirror.

18. Lithographic apparatus according to any of the claims 11-17, arranged to provide a predetermined halogen gas to the surface of the mirror.

19. A device manufacturing method comprising the steps of:
- providing a substrate;
- providing a projection beam of radiation using an illumination system;
- using patterning means to impart the projection beam with a pattern in its cross-section; and
- projecting the patterned beam of radiation onto a target portion of the substrate,
**characterized by**
using a mirror in said illumination system as defined in any of the claims 7-10 or a mirror provided with a top layer that is used as defined in any of the claims 1-6.

20. A lithographic apparatus comprising:
- an illumination system for providing a projection beam of radiation;
- a support structure for supporting patterning means, the patterning means serving to impart the projection beam with a pattern in its cross-section;
- a substrate table for holding a substrate; and
- a projection system for projecting the patterned beam onto a target portion of the substrate,
**characterized in that**
said lithographic apparatus comprises a source (SO) to provide radiation of a desired wavelength and that, in operation, generates a stream of undesired metal particles, the illumination system comprising a mirror arranged to receive at least some of said undesired metal particles when said lithographic apparatus is in operation, the lithographic apparatus moreover comprising a heating source to heat said mirror and increase surface mobility of said metal particles on said mirror.

21. Lithographic apparatus according to claim 20, wherein said mirror is a mirror according to any of the claims 7-10 or said mirror is provided with a top layer that is used as defined in any of the claims 1-6.

22. Lithographic apparatus according to claim 20 or 21, wherein said lithographic apparatus comprises a pump (29) for pumping away undesired metal vapor evaporated from said mirror.

23. Lithographic apparatus according to claim 20, 21 or 22, wherein said lithographic apparatus comprises a plurality of mirrors arranged as a radiation collector, at least one mirror comprising a rear surface facing a front surface of another mirror, said rear surface of said at least one mirror being arranged to receive metal particles evaporated from said front surface of said another mirror and to operate as a condensation surface.

24. Lithographic apparatus according to any of the claims 20-23, arranged to provide a predetermined halogen gas to the surface of the mirror.

25. A device manufacturing method comprising the steps of:
- providing a substrate;
- providing a projection beam of radiation using an illumination system;
- using patterning means to impart the projection beam with a pattern in its cross-section; and
- projecting the patterned beam of radiation onto a target portion of the substrate,
**characterized by**
providing a source (SO) to provide radiation of a desired wavelength to produce said projection beam and that, in operation, generates a stream of undesired metal particles, providing a mirror in the illumination system arranged to receive at least some of said undesired metal particles, and heating said mirror to increase surface mobility of said metal particles on said mirror.
